# EUROPEAN PATENT SPECIFICATION

(11) **EP 0 977 046 B1**
(45) Date of publication and mention of the grant of the patent: **02.03.2005**
(21) Application number: 99202407.5
(22) Date of filing: 21.07.1999
(51) Int. Cl.: G01R 31/327, H01H 33/66

(54) **Method and apparatus for testing the quality of the vacuum in a vacuum switch**
Vakuumqualitätsprüfeinrichtung und Verfahren für Vakuumschaltkammern
Dispositif et méthode de test de la qualité de vide pour des commutateurs en chambre à vide

(30) Priority: 27.07.1998 NL 1009741
(43) Date of publication of application: 02.02.2000
(73) Proprietor: N.V. Kema, 6812 AR Arnhem (NL)
(72) Inventor: Smeets, René Peter Paul, 6812 DN Arnhem (NL); Rutgers, Wijnand Reijer, 6662 XD Elst (NL)
(74) Representative: Eveleens Maarse, Pieter

(56) References cited:
- CH-A- 598 353
- DE-A- 3 643 672
- G.C. DAMSTRA ET. AL.: "Pressure Estimation in Vacuum Circuit Breakers" IEEE TRANSACTIONS ON DIELECTRICS AND ELECTRICAL INSULATION, vol. 2, no. 2, April 1995 (1995-04), pages 198-201, XP002098784

## Description

The present invention relates to a method for testing the quality of the vacuum in a vacuum switch, comprising of supplying a quantity of electrical charge to the contacts of the vacuum switch while the contacts are moved toward each other, and monitoring the progression of the voltage over or the current through the switch.

Such a method is known from the journal article "Pressure Estimation in Vacuum Circuit Breakers", G.C. Damstra et al, IEEE Transactions on Dielectrics and Electrical Insulation, vol. 2, no. 2, April 1995.

This method is used to measure the quality of the vacuum in a vacuum switch.

Vacuum switches have been in use for some decades. They are evacuated during production and then sealed in gas-tight manner. The quality of the vacuum may deteriorate during the lifetime of such vacuum switches.

It will be apparent that it is of the greatest importance that the qualities for circuit-breaking of the short-circuiting currents for which the switch is dimensioned must remain unimpaired. The quality of the vacuum is an important factor here. Because, as stated, the vacuum may deteriorate during the lifetime of the switch, it is important to determine the quality of the vacuum.

According to the above described method the quality of the vacuum cannot be determined.

Experience has shown that adsorption of gas atoms in the switch takes place particularly through the contacts. During measurement of the vacuum with the above stated method these adsorbed atoms are not released. This measurement is hereby found not to be a good reflection of the phenomena occurring during circuit-breaking of short-circuiting currents. Desorption of the atoms and molecules from the contacts in fact takes place here, whereby the quality of the vacuum is greatly reduced during switching and the circuit-breaking capacity is greatly decreased.

Nor does a high-voltage test of the breakdown voltage indicate a reduced circuit-breaking capacity.

The present invention provides a method wherein the circuit-breaking conditions are simulated as precisely as possible.

This objective is achieved by the above stated method, wherein the quantity of electrical charge is chosen such that adsorbed gas is released from the contacts.

As a result of these measures a good simulation of the phenomena occurring during circuit-breaking of short-circuiting power takes place during the measurement in accordance with the method according to the invention, so that a good indication is obtained of the quality of the switch.

It is pointed out here that a method is known from DE-A-36 43 672 for measuring the quality of the vacuum in a vacuum switch.

In this known method a high-frequency current is conducted through the closed contacts. The contacts are subsequently opened and the progression of the current through the switch is measured.

The progression of the current in the arc phase greatly depends herein on the synchronization between the generator for the high-frequency switch current and the mechanical operation of the switch, whereby it is possible to achieve reproducible measurement results.

In the method according to the invention on the other hand, closing of the contacts forms the initiation of the measurement; there are no problems of synchronization.

The quantity of charge is preferably supplied from a charged capacitor. This results in a simple and safe embodiment, wherein the danger of destruction of the switch is avoided as far as possible.

In the prior art according to DE-A-36 43 672 the generator comprises an initially charged capacitor which serves as generator during generation of the current through the switch. The current generated by the capacitor is therefore always decreasing. This also results in indeterminate conditions during opening of the contacts of the switch.

According to the invention however, the capacitor is spontaneously discharged by the switching operation, so that the charged condition of the capacitor is well defined at each measurement.

According to another preferred embodiment the charge is supplied via an inductance.

The combination of a capacitor and an inductance results in a resonant circuit, the resonance frequency of which is at least two orders of magnitude greater than the mains frequency. The time between ignition of the discharge and contact touch is herein also sufficiently long.

When sufficient charge is transported the desorption capacity of the measuring method becomes sufficiently large.

It is particularly important in the case of an alternating current switch that no re-ignition takes place during circuit-breaking, when the arc between contacts has disappeared as a result of the zero passage of current. In order to also enable simulation of this situation which occurs in reality the charge charges a capacitor which is arranged parallel to the switch and which applies a voltage to the switch immediately after the zero passage.

According to another preferred embodiment the progression of the current through or the voltage over the switch is monitored by determining at least one of these quantities and subsequently deriving the quality of the vacuum from the monitored quantity.

Good monitoring of the phenomena, which generally occur very rapidly, hereby becomes possible so that the behaviour of the switch can be properly inspected and documented.

The present invention further provides such a method, wherein the switch is incorporated in a switch bay, the switch is transported together with the drive mechanism out of the switch bay and the method according to any of the foregoing claims is then performed.

When the switch is transported out of the bay it is in any case isolated relative to the network in which the switch is normally included, so that the switch is per se available for testing.

Finally, the present invention provides a device for monitoring the quality of the vacuum in a vacuum switch, comprising:
- a first capacitor;
- a charging circuit for charging the capacitor;
- means for connecting the first capacitor to the contacts of the switch; and
- monitoring means for monitoring the progression of the current through or the voltage over the switch.

This device enables the method according to the present invention to be applied with little equipment.

The present invention will be elucidated hereinbelow with reference to the annexed figures, in which:
figure 1 shows a cross-sectional view of a vacuum switch;
figure 2 shows a diagram of the measuring circuit according.to the invention;
figures 3A, 3B show diagrams of the progression of current respectively voltage and measurement according to the invention at an increased gas pressure in the vacuum switch; and
figures 4A, 4B show diagrams of the progression of current respectively voltage in the case of a good vacuum in the switch.

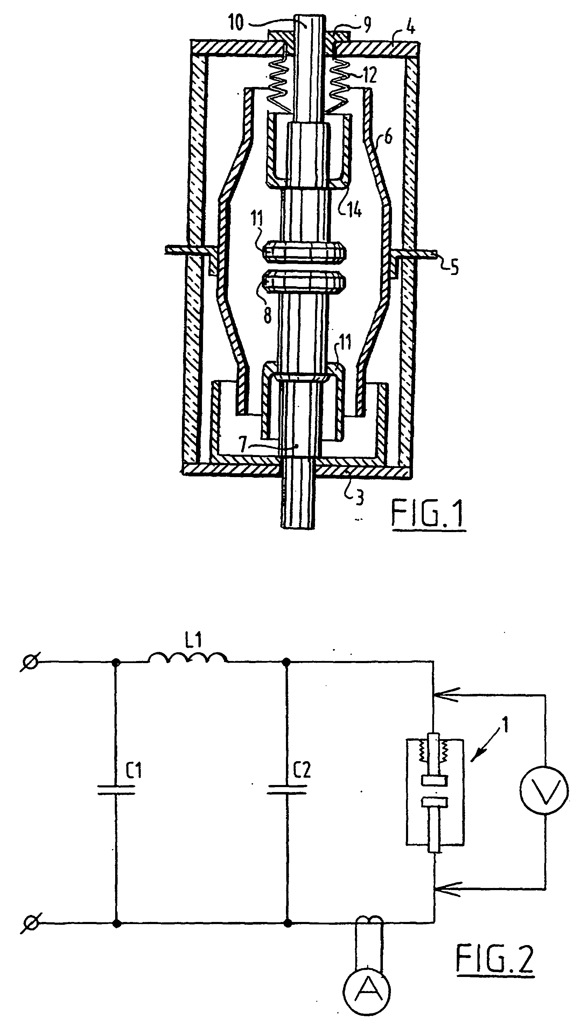

Figure 1 shows a vacuum switch 1 which is formed by a gastight housing formed by a housing 2 generally manufactured from ceramic material, a bottom plate 3 and a cover 4. In the present case the housing 2 is divided into two pieces separated by a ring 5 for positioning of a shield 6 in the switch housing.

Arranged in the bottom is an opening through which is inserted a rod 7 on which is mounted a fixed contact 8. In cover 4 is arranged an opening in which is placed a bearing 9 through which a rod 10 is movable in axial direction. A movable contact 11 is mounted on rod 10. The gastight closure between cover 4 and rod 10 is ensured by a bellows 12. Shields 13 respectively 14 are further arranged in the switch to collect metal vapour.

During the measurement according to the present invention use is made of the measuring circuit shown in figure 2. A capacitor C1 is herein used, one side of which is connected via an inductance L1 to one contact of the switch, while the other side of capacitor C1 is connected to the other side of the switch. A voltmeter V is further arranged which is connected to measure the voltage over the switch and an ammeter A is arranged to measure the current through the switch. It will be apparent that both instruments are recording instruments, for instance in the form of an oscilloscope, digital recorder and so on.

According to a preferred embodiment use is made of a capacitor C2 to adjust the recovery voltage.

In order to perform the method according to the present invention the capacitor C1 is charged with a charging circuit not shown in the drawing; this can simply be formed by a rectifier followed by a charging resistance. Contacts 8, 11 are herein in the opened position. The charging circuit is then isolated and a switch-on command is given. At a given moment, depending on the distance between the contacts, flash-over will herein occur, whereafter capacitor C1 discharges over the switch contacts. After interruption of the discharge current, charging of capacitor C2 will take place so that once the initial discharge has taken place a recovery voltage is applied over the contacts.

A measure can be derived for the circuit-breaking capacity of the vacuum switch from the moment at which the discharge is extinguished.

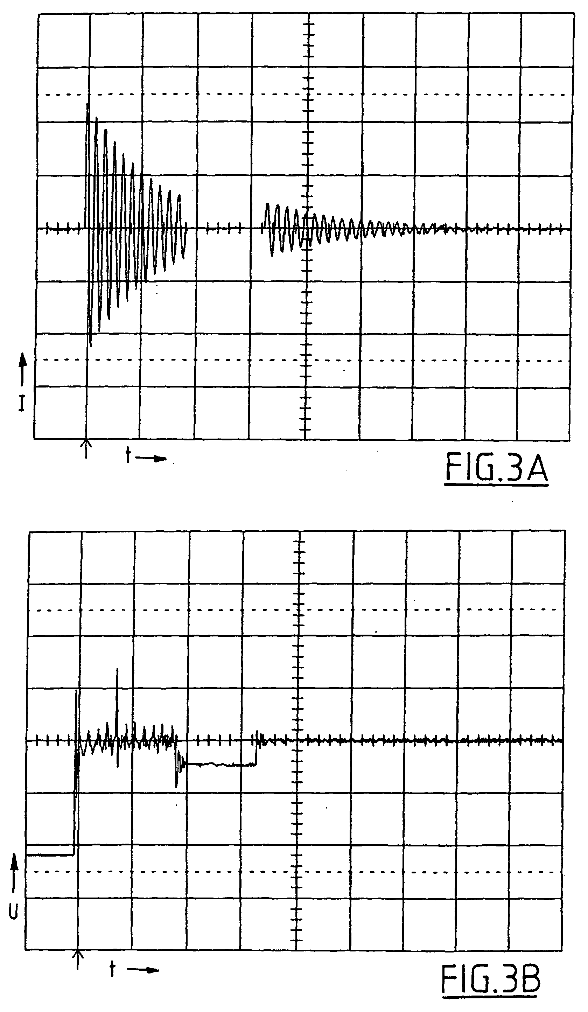

Various aspects are further elucidated in figures 3A, 3B which show the progression of the current through respectively the voltage over the switch when gas has leaked in.

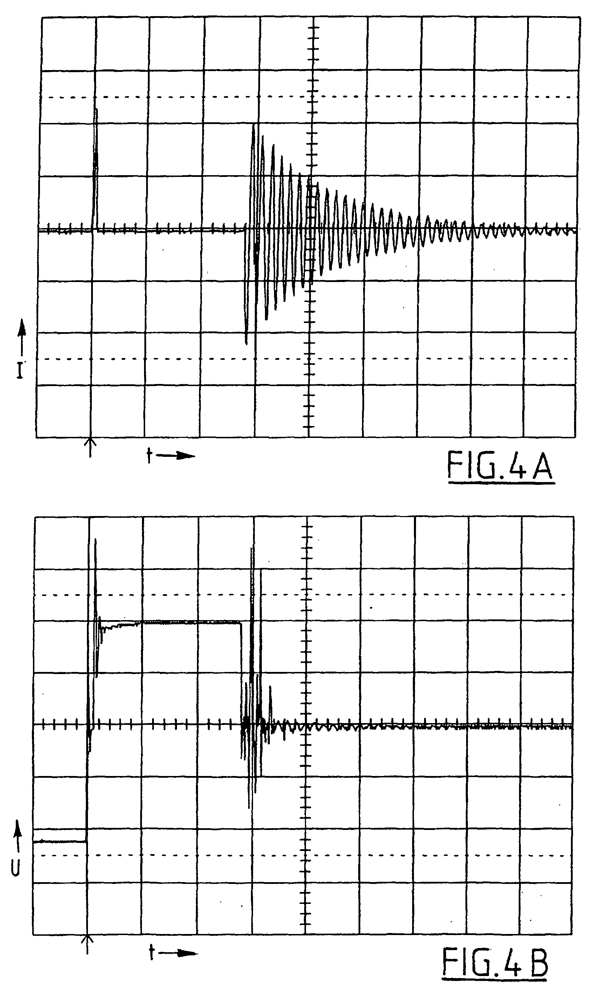

Figures 4A respectively 4B show the same quantities of a switch in which a good vacuum prevails.

## Claims

1. Method for testing the quality of a vacuum in a vacuum switch, comprising of supplying a quantity of electrical charge to the contacts of the vacuum switch while the contacts are moved toward each other, and monitoring the progression of the voltage over or the current through the switch, **characterized in that** the quantity of electrical charge is chosen such that adsorbed gas is released from the contacts.

2. Method as claimed in claim 1, **characterized in that** the quantity of charge is supplied from a charged capacitor.

3. Method as claimed in claim 1 or 2, **characterized in that** the charge is supplied via an inductance, the value of which is chosen such that the resonance frequency is greater than the nominal mains frequency.

4. Method as claimed in claim 3, **characterized in that** the charge charges a second capacitor arranged parallel to the switch, which second capacitor applies a voltage to the switch immediately after extinguishing of the discharge.

5. Method as claimed in any of the foregoing claims, **characterized in that** the progression of the current through or the voltage over the switch is monitored by determining at least one of these quantities and subsequently deriving the quality of the vacuum from the monitored quantity.

6. Method as claimed in any of the foregoing claims, **characterized in that** the switch is incorporated in a switch bay, is initially isolated from the switch bay and the method according to any of the foregoing claims is then performed.

7. Device for monitoring the quality of the vacuum in a vacuum switch, comprising:
- a first capacitor;
- a charging circuit for charging the capacitor;
- means for connecting the first capacitor to the contacts of the switch; and
- monitoring means for monitoring the progression of the current through or the voltage over the switch.

## Patentansprüche

1. Verfahren zum Testen der Qualität eines Vakuums in einem Vakuumschalter, umfassend ein Einspeisen einer elektrischer Ladungsmenge in die Kontakte des Vakuumschalters, während die Kontakte aufeinander zu bewegt werden, und Monitorierung eines Verlaufes der Spannung über oder des Stromes durch den Schalter, **dadurch gekennzeichnet, dass** die elektrische Ladungsmenge so gewählt ist, dass absorbiertes Gas von den Kontakten freigesetzt wird.

2. Verfahren nach Anspruch 1, **dadurch gekennzeichnet, dass** die Ladungsmenge von einem Kondensator eingespeist wird.

3. Verfahren nach Anspruch 1 oder 2, **dadurch gekennzeichnet, dass** die Ladung über eine Induktivität eingespeist wird, deren Wert so bemessen ist, dass die Resonanzfrequenz größer als die Nennnetzfrequenz ist.

4. Verfahren nach Anspruch 3, **dadurch gekennzeichnet, dass** die Ladung einen zweiten Kondensator auflädt, der parallel zum Schalter angeordnet ist, welcher dem Schalter eine Spannung unmittelbar nach Erlöschen der Entladung aufprägt.

5. Verfahren gemäß einem der vorhergehenden Ansprüche, **dadurch gekennzeichnet, dass** der Verlauf des Stromes durch oder der Spannung über den Schalter monitoriert wird, indem wenigstens eine dieser Größen bestimmt wird und anschließend die Qualität des Vakuums von der monitorierten Größe abgeleitet wird.

6. Verfahren gemäß einem der vorhergehenden Ansprüche, **dadurch gekennzeichnet, dass** der Schalter in ein Schaltfeld eingebaut ist, zunächst von dem Schaltfeld isoliert wird und dann das Verfahren gemäß einem der vorhergehenden Ansprüche durchgeführt wird.

7. Vorrichtung zur Monitorierung der Qualität des Vakuums in einem Vakuumschalter, umfassend: Einen ersten Kondensator; einen Ladestromkreis zum Laden des Kondensators; Mittel zum Verbinden des ersten Kondensators mit den Kontakten des Schalters; und Monitorierungsmittel zur Monitorierung des Verlaufes des Stromes durch oder der Spannung über den Schalter.

## Revendications

1. Procédé pour tester la qualité d'un vide dans un interrupteur à vide, comprenant l'apport d'une quantité de charge électrique aux contacts de l'interrupteur à vide tandis que les contacts sont déplacés l'un vers l'autre, et la surveillance de la progression de la tension ou de l'intensité à travers l'interrupteur, **caractérisé en ce que** la quantité de charge électrique est choisie afin que du gaz absorbé soit libéré par les contacts.

2. Procédé selon la revendication 1, **caractérisé en ce que** la quantité de charge est fournie par un condensateur chargé.

3. Procédé selon la revendication 1 ou 2, **caractérisé en ce que** la charge est fournie par une inductance, dont la valeur est choisie de telle sorte que la fréquence de résonance est supérieure à la fréquence nominale du réseau électrique.

4. Procédé selon la revendication 3, **caractérisé en ce que** la charge charge un second condensateur branché de manière parallèle à l'interrupteur, lequel second condensateur applique une tension à l'interrupteur immédiatement après l'extinction de la décharge.

5. Procédé selon l'une quelconque des revendications précédentes, **caractérisé en ce que** la progression de l'intensité ou de la tension à travers l'interrupteur est surveillée en déterminant au moins l'une de ces quantités et en déduisant consécutivement la qualité du vide à partir de la quantité surveillée.

6. Procédé selon l'une quelconque des revendications précédentes, **caractérisé en ce que** l'interrupteur est intégré à une travée, est initialement isolé de la travée et le procédé selon l'une quelconque des revendications précédentes est ensuite appliqué.

7. Dispositif pour surveiller la qualité du vide dans un interrupteur à vide, comprenant :
- un premier condensateur ;
- un circuit de charge pour charger le condensateur ;
- un moyen pour relier le premier condensateur aux contacts de l'interrupteur ; et
- un moyen de surveillance pour surveiller la progression de l'intensité ou de la tension à travers l'interrupteur.
